# EUROPEAN PATENT SPECIFICATION

(11) **EP 1 613 789 B1**
(45) Date of publication and mention of the grant of the patent: **24.12.2008**
(21) Application number: 04750189.5
(22) Date of filing: 16.04.2004
(51) Int. Cl.: C23C 16/18, C30B 25/02, C30B 29/02, C07C 249/02, C07C 249/16

(54) **VOLATILE COPPER(I) COMPLEXES FOR DEPOSITION OF COPPER FILMS BY ATOMIC LAYER DEPOSITION**
FLÜCHTIGE KUPFER (I) KOMPLEXE ZUR ABSCHEIDUNG VON KUPFERSCHICHTEN MITTELS ATOMSCHICHTABSCHEIDUNG (ALD)
COMPLEXES DE CUIVRE (I) VOLATILS PERMETTANT LE DEPOT DE FILMS DE CUIVRE PAR DEPOT DE COUCHES ATOMIQUES

(30) Priority: 16.04.2003 US 463170 P
(43) Date of publication of application: 11.01.2006
(73) Proprietor: E.I. DU PONT DE NEMOURS AND COMPANY, Wilmington, DE 19898 (US)
(72) Inventor: BRADLEY, Alexander, Zak, Drexel Hill, PA 19026 (US); THOMPSON, Jeffery, Scott, Wilmington, DE 19803 (US)
(74) Representative: Towler, Philip Dean
(86) International application number: PCT/US2004/011734
(87) International publication number: WO 2004/094689

(56) References cited:
- WO-A-03/095701
- DE-A- 4 202 889
- US-A1- 2001 055 877
- US-B1- 6 372 928
- US-B1- 6 511 936
- MCGEACHIN S G: "SYNTHESIS AND PROPERTIES OF SOME BETA-DIKETIMINES DERIVED FROM ACETYLACETONE, AND THEIR METAL COMPLEXES" CANADIAN JOURNAL OF CHEMISTRY - JOURNAL CANADIEN DE CHIMIE, XX, XX, vol. 46, no. 11, 1968, pages 1903-1912, XP000961572 ISSN: 0008-4042

## Description

### FIELD OF THE INVENTION

The present invention relates to novel 1,3-diimine copper complexes and the use of 1,3-diimine copper complexes for the deposition of copper on substrates or in or on porous solids in an atomic layer deposition process.

### TECHNICAL BACKGROUND

Atomic layer deposition (ALD) processes are useful for the creation of thin films, as described by M. Ritala and M. Leskela in "Atomic Layer Deposition" in Handbook of Thin Film Materials, H. S. Nalwa, Editor, Academic Press, San Diego, 2001, Volume 1, Chapter 2. Such films, especially metal and metal oxide films, are critical components in the manufacture of electronic circuits and devices.

In an ALD process for depositing copper films, a copper precursor and a reducing agent are alternatively introduced into a reaction chamber. After the copper precursor is introduced into the reaction chamber and allowed to adsorb onto a substrate, the excess (unadsorbed) precursor vapor is pumped or purged from the chamber. This process is followed by introduction of a reducing agent that reacts with the copper precursor on the substrate surface to form copper metal and a free form of the ligand. This cycle can be repeated if needed to achieve the desired film thickness.

This process differs from chemical vapor deposition (CVD) in the decomposition chemistry of the metal complex. In a CVD process, the complex decomposes on contact with the surface to give the desired film. In an ALD process, the complex is not decomposed to metal on contact with the surface. Rather, formation of the metal film takes place on introduction of a second reagent, which reacts with the deposited metal complex. In the preparation of a copper film from a copper(I) complex, the second reagent is a reducing agent. Advantages of an ALD process include the ability to control the film thickness and improved conformality of coverage because of the self-limiting adsorption of the precursor to the substrate surface in the first step of the process.

To be useful in an ALD process, the copper complex must be volatile enough to be vaporized without thermal decomposition. Typically, trifluoromethyl group-containing ligands have been used to increase the volatility of the copper complexes. However this approach has drawbacks in the preparation of interconnect layers, because residual halides adversely affect the properties of the interconnect layer.

The ligands used in the ALD processes must also be stable with respect to decomposition and be able to desorb from the complex in a metal-free form. Following reduction of the copper, the ligand is liberated and must be removed from the surface to prevent its incorporation into the metal layer being formed.

US 5,464,666 describes the decomposition of 1,3-diimine copper complexes in the presence of hydrogen to form copper. This patent also describes the use of 1,3-diimine copper complexes in a Chemical Vapor Deposition process for producing copper-aluminum alloys.

DE 4202889 describes the use of 1,3-diimine metal complexes to deposit coatings, preferably via a Chemical Vapor Deposition process. Decomposition of the metal complexes in a reducing atmosphere, preferably hydrogen, is disclosed.

S.G. McGeachin, Canadian Journal of Chemistry, 46, 1903-1912 (1968), describes the synthesis of 1,3-diimines and metal complexes of these ligands, including bis-chelate or homoleptic complexes of the form ML₂.

US 6,464,779 discloses a Cu atomic layer CVD process that requires treatment of a copper precursor containing oxygen and fluorine with an oxidizing agent to form copper oxide, followed by treatment of the surface with a reducing agent.

### SUMMARY OF THE INVENTION

This invention describes a process for forming copper deposits on a substrate comprising:
a. contacting a substrate with a copper complex, (I), to form a deposit of a copper complex on the substrate; and 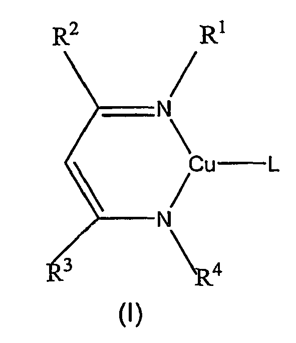
b. contacting the deposited copper complex with a reducing agent, wherein
   L is an olefin comprising 2 - 15 carbons;
   R¹ and R⁴ are independently selected from the group consisting of hydrogen, methyl, ethyl, propyl, isopropyl, isobutyl, and neopentyl;
   R² and R³ are independently selected from the group consisting of phenyl and C₁-C₁₀ alkyl groups; and
   the reducing agent is selected from the group consisting of 9-BBN (9-borabicyclo[3.3.1]nonane); diborane; boranes of the form BRₓH₃₋ₓ, where x = 0, 1 or 2, and R is independently selected from the group consisting of phenyl and C₁-C₁₀ alkyl groups; dihydrobenzofuran; pyrazoline; disilane; silanes of the form SiR'_{y}H_{4-y}, where y = 0, 1, 2 or 3, and R' is independently selected from the group consisting of phenyl and C₁-C₁₀ alkyl groups; and germanes of the form GeR"_{z}H_{4-z}, where z = 0, 1, 2, or 3, and R" is independently selected from the group consisting of phenyl and G₁-C₁₀ alkyl groups.

### DETAILED DESCRIPTION

Applicants have discovered an atomic layer deposition (ALD) process suitable for creation of copper films for use as seed layers in the formation of copper interconnects in integrated circuits, or for use in decorative or catalytic applications. This process uses copper(I) complexes that are volatile, thermally stable and derived from ligands that contain only C, H, Si and N. The ligands are chosen to form copper(I) complexes that are volatile in an appropriate temperature range but do not decompose to copper metal in this temperature range; rather, the complexes decompose to metal on addition of a suitable reducing agent. The ligands are further chosen so that they will desorb without decomposition upon exposure of the copper complex to a reducing agent. The reduction of these copper complexes to copper metal by readily available reducing agents has been demonstrated to proceed cleanly at moderate temperatures.

In the process of this invention, copper is deposited on a substrate by means of:
a. contacting a substrate with a copper complex, (I), to form a deposit of a copper complex on the substrate; and 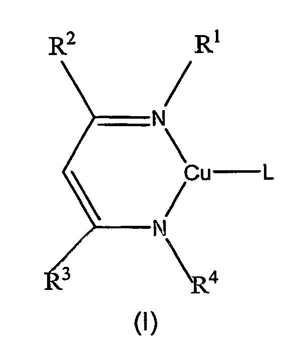
b. contacting the deposited copper complex with a reducing agent, wherein
   L is an olefin comprising 2 - 15 carbons;
   R¹ and R⁴ are independently selected from the group consisting of hydrogen, methyl, ethyl, propyl, isopropyl, isobutyl, and neopentyl;
   R² and R³ are independently selected from the group consisting of phenyl and C₁-C₁₀ alkyl groups; and
   the reducing agent is selected from the group consisting of 9-BBN; diborane; boranes of the form BRₓH₃₋ₓ, where x = 0, 1 or 2, and R is independently selected from the group consisting of phenyl and C₁-C₁₀ alkyl groups; dihydrobenzofuran; pyrazoline; disilane; silanes of the form SiR'_{y}H_{4-y}, where y = 0, 1, 2 or 3, and R' is independently selected from the group consisting of phenyl and C₁-C₁₀ alkyl groups; and germanes of the form GeR"_{z}H_{4-z}, where z = 0, 1, 2, or 3, and R" is independently selected from the group consisting of phenyl and C₁-C₁₀ alkyl groups.

The deposition process of this invention improves upon the processes described in the art by allowing the use of lower temperatures and producing higher quality, more uniform films. The process of this invention also provides a more direct route to a copper film, avoiding the formation of an intermediate oxide film.

In the copper deposition process of this invention, the copper can be deposited on the surface, or in or on porosity, of the substrate. Suitable substrates include conducting, semiconducting and insulating substrates, including copper, silicon wafers, wafers used in the manufacture of ultra large scale integrated circuits, wafers prepared with dielectric material having a lower dielectric constant than silicon dioxide, and silicon dioxide and low k substrates coated with a barrier layer. Barrier layers to prevent the migration of copper include tantalum, tantalum nitride, titanium, titanium nitride, tantalum silicon nitride, titanium silicon nitride, tantalum carbon nitride, and niobium nitride.

This process can be conducted in solution, i.e., by contacting a solution of the copper complex with the reducing agent. However, it is preferred to expose the substrate to a vapor of the copper complex, and then remove any excess copper complex (i.e., undeposited complex) by vacuum or purging before exposing the deposited complex to a vapor of the reducing agent. After reduction of the copper complex, the free form of the ligand can be removed via vacuum, purging, heating, rinsing with a suitable solvent, or a combination of such steps.

This process can be repeated to build up thicker layers of copper, or to eliminate pin-holes.

The deposition of the copper complex is typically conducted at 0 to 200 °C. The reduction of the copper complex is typically carried out at similar temperatures, 0 to 200 °C.

In the process of this invention, it is initially a copper complex that is deposited on the substrate. The formation of a metallic copper film does not occur until the copper complex is exposed to the reducing agent.

Aggressive reducing agents are needed to reduce the copper complex rapidly and completely. Reducing agents must be volatile and not decompose on heating. They must also be of sufficient reducing power to react rapidly on contact with the copper complex deposited on the substrate surface. A group of suitable reducing agents has been identified that have not previously been used for copper(I) reduction in an ALD process. One feature of these reagents is the presence of a proton donor. The reagent must be able to transfer at least one electron to reduce the copper ion of the complex and at least one proton to protonate the ligand. The oxidized reducing agent and the protonated ligand must be able to be easily removed from the surface of the newly formed copper deposit.

Suitable reducing agents for the copper deposition process of this invention include 9-BBN, borane, diborane, dihydrobenzofuran, pyrazoline, germanes, diethylsilane, dimethylsilane, ethylsilane, phenylsilane, silane and disilane. Diethylsilane and silane are preferred.

In one embodiment of the copper deposition process, the copper complexes are added to a reactor under conditions of temperature, time and pressure to attain a suitable fluence of complex to the surface of the substrate. One of skill in the art will appreciate that the selection of these variables will depend on individual chamber and system design, and the desired process rate. After at least a portion of the copper complex has been deposited on the substrate (e. g., a coated silicon wafer), the undeposited complex vapor is pumped or purged from the chamber and the reducing agent is introduced into the chamber at a pressure of approximately 50 to 760 mTorr (6.7 to 100 Pa) to reduce the adsorbed copper complex. The substrate is held at a temperature between approximately 0 to 200°C during reduction. With suitable combinations of copper complex and reducing agent, this reduction is rapid and complete. Reducing agent exposure times can be from less than a second to several minutes. It is important that the products from this reaction are readily removed from the surface of the substrate under the reducing conditions.

In one embodiment of this invention, the copper complex is a copper 1,3-diimine complex (I), wherein R¹ and R⁴ are isobutyl groups, R² and R³ are methyl groups, and L= vinyltrimethylsilane, and the reducing agent is diethylsilane.

This invention also provides novel 1,3-diimine copper complexes, (I), 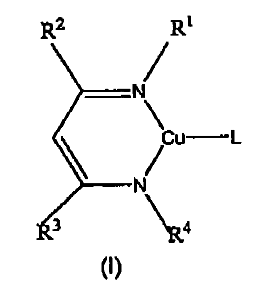 wherein L is an olefin comprising 2-15 carbons;
R¹ and R⁴ are independently selected from the group consisting of hydrogen, methyl, ethyl, propyl, isopropyl, isobutyl, and neopentyl; and
R² and R³ are independently selected from the group consisting of phenyl and C₁-C₁₀ alkyl groups.

In one embodiment, L is a linear, terminal olefin. For olefins of 4-15 carbons, L can also be an internal olefin of cis- or trans-configuration; cis- is preferred. L can be a cyclic or bicyclic olefin. L can also be substituted, for example with silyl groups. Suitable olefins include vinyltrimethylsilane, allyltrimethylsilane, 1-hexene, 4-methyl-1-pentene, 3,3-dimethyl-1-butene, and norbornene.

The synthesis of one particular ligand useful for making the copper complexes of this invention is given in Example 1, below. Other ligands can be prepared similarly from analogous amino ketones.

In another embodiment, this invention provides an article comprising 1,3-diimine copper complexes (I) deposited on a substrate. Suitable substrates include: copper, silicon wafers, wafers used in the manufacture of ultra large scale integrated circuits, wafers prepared with dielectric material having a lower dielectric constant than silicon dioxide, and silicon dioxide and low k substrates coated with a barrier layer. Barrier layers can be used to prevent the migration of copper. Suitable barrier layers include: tantalum, tantalum nitride, titanium, titanium nitride, tantalum silicon nitride, titanium silicon nitride, tantalum carbon nitride, and niobium nitride.

### EXAMPLES

All organic reagents are available from Sigma-Aldrich Corporation (Milwaukee, WI, USA). [Cu(CH₃CN)₄]SO₃CF₃ can be prepared according to the method described in: T. Ogura, Transition Metal Chemistry, 1, 179-182 (976).

### EXAMPLE 1

### Preparation and Reduction of Vinyltrimethylsilane(N,N'-diisobutyl-2,4-pentanediketiminate)copper

In a dry box under a nitrogen atmosphere, a 250 mL round-bottom flask was charged with 4-(isobutylamino)-3-pentene-2-one (36.9 g, 237 mmole) and dimethylsulfate (30.0 g, 237 mmole). The reaction solution was stirred for 5 minutes and then allowed to stand without stirring overnight. The yellow mixture became orange and viscous. Isobutyl amine (18 g, 246 mmole) was added with vigorous stirring via addition funnel. The solution was stirred for one hour until it solidified. The intermediate salt was not isolated, but was directly converted to the free amine (based on the theoretical yield of the intermediate salt) as described below.

A solution of NaOMe (12.8 g, 237 mmole) in MeOH (ca 40 mL) was added to the intermediate salt and stirred for one hour. The solvent was removed under vacuum to give a yellow oil that was extracted with pentane, filtered, and concentrated to give a yellow oil that consisted of the desired product (N,N'-diisobutyl-2,4-pentanediketimine) (ca 75%) and unreacted starting material (ca. 25%) based on proton NMR data. The product was isolated by fractional distillation to give a yellow oil (35.4 g, 72% yield).

In the dry box, a 100 mL round-bottom flask was charged with [Cu(CH₃CN)₄]SO₃CF₃ (1.0 g), vinyltrimethylsilane (26.0 mmole), and diethyl ether (20 mL). In a separate 100 mL round-bottom flask, 1. 5 M *t*-butyl lithium (1.7 mL) was added to a solution of N,N'-diisobutyl-2,4-pentane-diketimine (0.550 g), prepared as described above. After 0.5 h, the solutions were combined. The combined solution changed from a cloudy white suspension to a golden-brown, clear solution after the uptake of all solids. After 2 h, the solution was concentrated to a solid/sludge, extracted with pentane (3 x 15 mL), filtered and concentrated to give a viscous oil (0.600 g, 62% yield).

### EXAMPLE 2

The viscous oil isolated as the final product in Example 1 was used as a copper precursor to create a copper film on a substrate. The substrate consisted of a silicon dioxide wafer with 250-A layer of tantalum and a 100Å layer of copper. The wafer had a barely discernable copper color.

Approximately 0.040 g of copper precursor was loaded in a dry box into a porcelain boat. The boat and wafer (∼1 cm²) were placed in a glass tube approximately 3.5 inches (9 cm) apart. The glass tube was removed from the dry box and attached to a vacuum line. Heating coils were attached to the glass tube surrounding both the area around the porcelain boat and the area around the wafer chip; this configuration allows the two areas to be maintained at different temperatures. Following evacuation of the system, an argon flow was created through the tube, passing first over the sample in the boat and then over the wafer. The pressure inside the tube was maintained at 150-200 mTorr (20-27 Pa). The region around the wafer was warmed to 110°C. After approximately an hour, the temperature of the region around the sample boat was raised to 55°C. These temperatures and the Ar gas flow were maintained for approximately 2.5 hours. The area around the sample boat was then cooled to room temperature. The tube was evacuated to a pressure of ∼10 mTorr (1.3 Pa) and was back-filled with diethylsilane. The area of the tube at 110°C quickly turned a copper color. The apparatus was cooled and returned to the dry box. The copper color was perceptively darker. The process was repeated to yield a wafer with a smooth metallic copper film.

## Claims

1. A process for forming copper deposits on a substrate comprising:
a. contacting a substrate with a copper (I) complex, (I), to form a deposit of a copper complex on the substrate; and 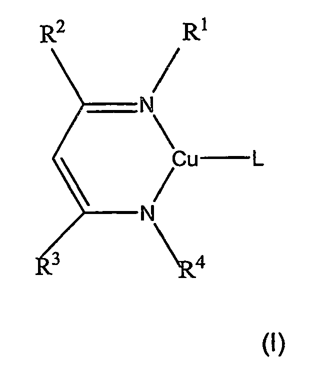
b. contacting the deposited copper complex with a reducing agent, wherein
L is an olefin comprising 2 - 15 carbons;
R¹ and R⁴ are independently selected from the group consisting of hydrogen, methyl, ethyl, propyl, isopropyl, isobutyl, and neopentyl;
R² and R³ are independently selected from the group consisting of phenyl and C₁-C₁₀ alkyl groups; and
the reducing agent is selected from the group consisting of 9-BBN; diborane; boranes of the form BRₓH₃₋ₓ, where x = 0, 1 or 2, and R is independently selected from the group consisting of phenyl and C₁-C₁₀ alkyl groups; dihydrobenzofuran; pyrazoline; disilane; silanes of the form SiR'_{y}H_{4-y}, where y = 0, 1, 2 or 3, and R' is independently selected from the group consisting of phenyl and C₁-C₁₀ alkyl groups; and germanes of the form GeR"_{z}H_{4-z}, where z = 0, 1, 2, or 3, and R" is independently selected from the group consisting of phenyl and C₁-C₁₀ alkyl groups.

2. The process of Claim 1, wherein R² and R³ are methyl and R¹ and R⁴ are isobutyl.

3. The process of Claim 1, wherein L is vinyltrimethylsilane.

4. The process of Claim 1, wherein the substrate is selected from the group consisting of copper, silicon wafers and silicon dioxide coated with a barrier layer.

5. The process of Claim 1, wherein the substrate is exposed to a vapor of the copper complex.

6. The process of Claim 1, wherein the deposition is carried out at 0 to 200 °C.

7. The process of Claim 1, wherein the reducing agent is silane or diethylsilane.

8. A 1,3-diimine copper (I) complex, (I), 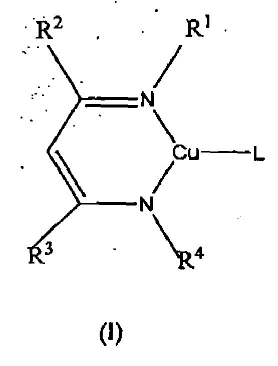 wherein
L is an olefin comprising 2 - 15 carbons;
R¹ and R⁴ are independently selected from the group consisting of hydrogen, methyl, ethyl, propyl, isopropyl, isobutyl, and neopentyl;
R² and R³ are independently selected from the group consisting of phenyl and C₁-C₁₀ alkyl groups.

9. The 1,3-diimine copper complex of Claim 8, wherein
L is vinyltrimethylsilane;
R¹ and R⁴ are selected from the group of hydrogen, isobutyl, and neopentyl;
R² is Me; and
R³ is selected from the group consisting of Me, Et, and phenyl.

10. An article produced by contacting a substrate with a 1,3-diimine copper complex of Claim 8, to form a deposit of the copper complex on the substrate.

11. The article of Claim 10, wherein the substrate is selected from the group of copper, silicon wafers, and silicon dioxide coated with a barrier layer.

12. The article of Claim 11, wherein the barrier layer is selected from the group consisting of tantalum, tantalum nitride, titanium, titanium nitride, tantalum silicon nitride, titanium silicon nitride, tantalum carbon nitride, and niobium nitride.

## Patentansprüche

1. Verfahren zur Bildung von Kupferabscheidungen auf einem Substrat, mit den folgenden Schritten:
a. Inkontaktbringen eines Substrats mit einem Kupfer(I)-Komplex (1) zur Bildung einer Abscheidung eines Kupferkomplexes auf dem Substrat; und 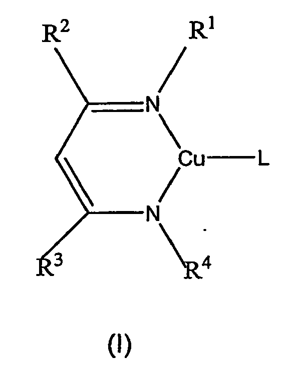
b. Inkontaktbringen des abgeschiedenen Kupferkomplexes mit einem Reduktionsmittel, wobei
L ein Olefin mit 2 - 15 Kohlenstoffatomen ist;
R¹ und R⁴ unabhängig voneinander aus der Gruppe ausgewählt sind, die aus Wasserstoff, Methyl, Ethyl, Propyl, Isopropyl, Isobutyl und Neopentyl besteht;
R² und R³ unabhängig voneinander aus der Gruppe ausgewählt sind, die aus Phenyl und C₁-C₁₀-Alkylgruppen besteht; und
das Reduktionsmittel aus der Gruppe ausgewählt ist, die aus 9-BBN; Diboran; Boranen der Form BRₓH₃₋ₓ besteht, wobei x = 0, 1 oder 2 ist und R unabhängig voneinander aus der Gruppe ausgewählt ist, die aus Phenyl und C₁-C₁₀-Alkylgruppen besteht; Dihydrobenzofuran, Pyrazolin; Disilan; Silanen der Form SiR'_{y}H_{4-y}, wobei y = 0, 1, 2 oder 3 ist und R' unabhängig voneinander aus der Gruppe ausgewählt ist, die aus Phenyl und C₁-C₁₀-Alkylgruppen besteht; und Germaniumwasserstoffen der Form GeR"_{z}H_{4-z} besteht, wobei z = 0, 1, 2 oder 3 ist und R" unabhängig voneinander aus der Gruppe ausgewählt ist, die aus Phenyl und C₁-C₁₀-Alkylgruppen besteht.

2. Verfahren nach Anspruch 1, wobei R² und R³ Methyl sind und R¹ und R⁴ Isobutyl sind.

3. Verfahren nach Anspruch 1, wobei L Vinyltrimethylsilan ist.

4. Verfahren nach Anspruch 1, wobei das Substrat aus der Gruppe ausgewählt ist, die aus Kupfer, Siliciumwafem und mit einer Sperrschicht überzogenem Siliciumdioxid besteht.

5. Verfahren nach Anspruch 1, wobei das Substrat einem Dampf des Kupferkomplexes ausgesetzt wird.

6. Verfahren nach Anspruch 1, wobei die Abscheidung bei 0 bis 200°C ausgeführt wird.

7. Verfahren nach Anspruch 1, wobei das Reduktionsmittel Silan oder Diethylsilan ist.

8. 1,3-Diimin-Kupfer(I)-Komplex (1), 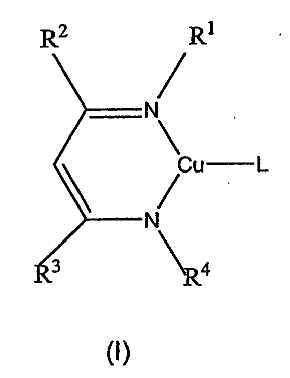 wobei
L ein Olefin mit 2 - 15 Kohlenstoffatomen ist;
R¹ und R⁴ unabhängig voneinander aus der Gruppe ausgewählt sind, die aus Wasserstoff, Methyl, Ethyl, Propyl, Isopropyl, Isobutyl und Neopentyl besteht;
R² und R³ unabhängig voneinander aus der Gruppe ausgewählt sind, die aus Phenyl und C₁-C₁₀-Alkylgruppen besteht.

9. 1,3-Diimin-Kupfer(I)-Komplex (1) nach Anspruch 8, wobei
L Vinyltrimethylsilan ist;
R¹ und R⁴ aus der Gruppe ausgewählt sind, die aus Wasserstoff, Isobutyl und Neopentyl besteht;
R² für Me steht; und
R³ aus der Gruppe ausgewählt ist, die aus Me, Et und Phenyl besteht.

10. Artikel, der durch Inkontaktbringen eines Substrats mit einem 1,3-Diimin-Kupferkomplex nach Anspruch 8 erzeugt wird, um eine Abscheidung des Kupferkomplexes auf dem Substrat zu bilden.

11. Artikel nach Anspruch 10, wobei das Substrat aus der Gruppe ausgewählt ist, die aus Kupfer, Siliciumwafem und mit einer Sperrschicht überzogenem Siliciumdioxid besteht.

12. Artikel nach Anspruch 11, wobei die Sperrschicht aus der Gruppe ausgewählt ist, die aus Tantal, Tantalnitrid, Titan, Titannitrid, Tantalsiliciumnitrid, Titansiliciumnitrid, Tantalkohlenstoffnitrid und Niobnitrid besteht.

## Revendications

1. Procédé de formation de dépôts de cuivre sur un substrat, qui comprend:
a. la mise en contact d'un substrat avec un complexe cuivreux (I) pour former un dépôt du complexe de cuivre sur le substrat; et 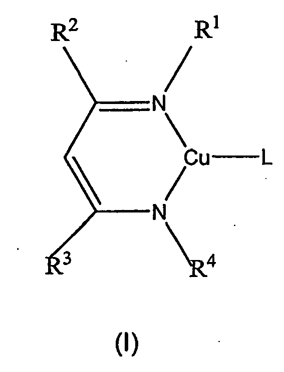
b. la mise en contact du complexe de cuivre déposé avec un agent réducteur, dans lequel
L est une oléfine à 2-15 carbones;
R¹ et R⁴ sont indépendamment sélectionnés dans le groupe constitué par hydrogène, méthyle, éthyle, propyle, isobutyle et néopentyle;
R² et R³ sont indépendamment sélectionnés dans le groupe constitué par un groupe phényle et des groupes alkyles en C₁-C₁₀; et
l'agent réducteur est sélectionné dans le groupe constitué par le 9-BBN; le diborane; des boranes de la forme BRₓH₃₋ₓ, où x = 0, 1 ou 2 et où R est indépendamment sélectionné dans le groupe constitué par un groupe phényle et des groupes alkyles en C₁-C₁₀; le dihydrobenzofurane; la pyrazoline; le disilane; des silanes de la forme SiR'_{y}H_{4-y}, où y = 0, 1, 2 ou 3 et où R' est indépendamment sélectionné dans le groupe constitué par un groupe phényle et des groupes alkyles en C₁-C₁₀; et des germanes de la forme GeR"_{z}H_{4-z}, où z = 0, 1, 2 ou 3 et où R" est indépendamment sélectionné dans le groupe constitué par un groupe phényle et des groupes alkyles en C₁-C₁₀.

2. Procédé de la revendication 1, où R² et R³ soent un groupe méthyle et R¹ et R⁴ un groupe isobutyle.

3. Procédé de la revendication 1, où L est le vinyltriméthylsilane.

4. Procédé de la revendication 1, où le substrat est sélectionné dans le groupe constitué par le cuivre, des tranches de silicium et le dioxyde de silicium enduit d'une couche barrière.

5. Procédé de la revendication 1, où le substrat est exposé à une vapeur du complexe de cuivre.

6. Procédé de la revendication 1, où le dépôt est effectué à une température comprise entre 0 et 200°C.

7. Procédé de la revendication 1, où l'agent réducteur est le silane ou le diéthylsilane.

8. Complexe 1,3-diimine cuivreux, (I), 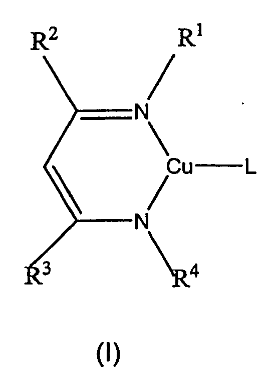 où
L est une oléfine à 2-15 carbones;
R¹ et R⁴ sont indépendamment sélectionnés dans le groupe constitué par hydrogène, méthyle, éthyle, propyle, isobutyle et néopentyle;
R² et R³ sont indépendamment sélectionnés dans le groupe constitué par un groupe phényle et des groupes alkyles en C₁-C₁₀.

9. Complexe 1,3-diimine cuivreux de la revendication 8, où
L est le vinyltriméthylsilane;
R¹ et R⁴ sont indépendamment sélectionnés dans le groupe constitué par hydrogène, isobutyle et néopentyle;
R² est un groupe Me; et
R³ est sélectionné dans le groupe constitué par un groupe Me, Et et phényle.

10. Article produit par la mise en contact d'un substrat avec un complexe de 1,3-diimine cuivreux de la revendication 8 pour former un dépôt du complexe de cuivre sur le substrat.

11. Article de la revendication 10, où le substrat est sélectionné dans le groupe constitué par le cuivre, des tranches de silicium et le dioxyde de silicium enduit d'une couche barrière.

12. Article de la revendication 11, où la couche barrière est sélectionnée dans le groupe constitué par le tantale, le nitrure de tantale, le titane, le nitrure de titane, le nitrure de tantale et de silicium, le nitrure de titane et de silicium, le nitrure de tantale et de carbone et le nitrure de niobium.
